# EUROPÄISCHE PATENTSCHRIFT

(11) **EP 2 271 196 B1**
(45) Veröffentlichungstag und Bekanntmachung des Hinweises auf die Patenterteilung: **14.03.2012**
(21) Anmeldenummer: 10004374.4
(22) Anmeldetag: 24.04.2010
(51) Int. Cl.: H05K 7/20, H01L 23/373, H01L 21/50

(54) **Verfahren zur Herstellung einer Stromeinrichteranordnung mit Kühleinrichtung und Stromrichteranordnung**
Method for producing a frequency converter with cooling device and frequency converter
Procédé de fabrication d'un dispositif de régulation du courant doté d'un dispositif de refroidissement et dispositif de régulation du courant

(30) Priorität: 09.06.2009 DE 102009024371
(43) Veröffentlichungstag der Anmeldung: 05.01.2011
(73) Patentinhaber: SEMIKRON Elektronik GmbH & Co. KG, 90431 Nürnberg (DE)
(72) Erfinder: Beckedahl, Peter, 90522 Nürnberg (DE); Göbl, Chrstian, 90441 Nürnberg (DE); Knebel, Markus, 90587 Tuchenbach (DE); Sagebaum geb. Herrmann, Ulrich, 90408 Nürnberg (DE)

(56) Entgegenhaltungen:
- EP-A1- 1 772 902
- WO-A2-02/49104
- DE-A1-102006 009 159

## Beschreibung

Die Erfindung betrifft ein Herstellungsverfahren und eine spezielle Stromrichteranordnung mit einer Kühleinrichtung. Derartige Stromrichteranordnungen sind bekannt als Kühleinrichtungen mit hierauf angeordneten Leistungshalbleitermodulen. Eine Stromrichterschaltung eines derartigen Leistungshalbleitermoduls besteht im Allgemeinen aus mindestens einem Substrat, welches seinerseits erste Leiterbahnen aufweist. Auf diesen Leiterbahnen sind Leistungshalbleiterbauelement angeordnet, verschaltet und mit externen Anschlüssen verbunden.

Leistungshalbleitermodule der oben genannten Art sind beispielhaft aus der DE 103 55 925 A1 bekannt. Das dort offenbarte Leistungshalbleitermodul weist mindestens ein Substrat mit schaltungsgerecht angeordneten Leiterbahnen auf, wobei auf diesen Leiterbahnen Leistungshalbleiterbauelemente und Distanzelemente angeordnet sind. Diese Elemente sind mit einem alternierenden Folienverbund aus mindestens zwei metallischen Folienschichten mit jeweils einer dazwischen angeordneten elektrisch isolierenden Folienschicht elektrisch leitend verbunden. Hierzu weist der Folienverbund Kontaktnoppen und Durchkontaktierungen auf. Dieser Folienverbund ist mit den Leistungshalbleiterbauelementen und den Distanzelementen mittels Ultraschallschweißen elektrisch leitend verbunden. WO0249104 A2 zeigt ein elektronisches Leistungsmodul das aus mindestens einem elektronischen Leistungsbauelement, einem DCB-Keramiksubstrat, einem Kühlkörper und mindestens einer zusätzlichen Wärmekapazität besteht, wobei a) die elektronischen Leistungsbauelemente über eine Sinterschicht an ihrer Unterseite mit der oberen Kupferschicht des DCB-Keramiksubstrates verbunden sind, b) die obere Kupferschicht des DCB-Keramiksubstrates zur elektrischen Kontaktierung der Leistungsbauelemente in Kupferleiterbahnen strukturiert ist, c) die untere Kupferschicht des DCB-Keramiksubstrates über eine Sinterschicht mit einen Kühlkörper verbunden ist, d) die Oberseiten der Leistungsbauelemente über eine Sinterschicht mit einer zusätzlichen Wärmekapazität verbunden sind.

Üblicherweise werden derartige Leistungshalbleitermodule auf den Kühleinrichtungen kraftschlüssig angeordnet. Hierzu sind meist Schraub- oder Klemmverbindungen zwischen dem Leistungshalbleitermodul und der Kühleinrichtung vorgesehen. Bei derartigen kraftschlüssigen Verbindungen ist zwischen den Verbindungspartner in der Regel eine Wärme leitende Schicht vorgesehen. Die hierfür eingesetzten Wärmeleitpasten weisen allerdings eine im Vergleich zu Metall, speziell zu Kupfer und Aluminium, geringe Wärmeleitfähigkeit auf.

Der Erfindung liegt die Aufgabe zugrunde ein Herstellungsverfahren und eine vorteilhafte Ausgestaltung einer Stromrichteranordnung vorzustellen, wobei der Wärmeübergang zur Kühleinrichtung besonders wirksam gestaltet ist.

Die Aufgabe wird erfindungsgemäß gelöst, durch ein Verfahren mit den Merkmalen des Anspruchs 1 und einen Gegenstand mit den Merkmalen des Anspruchs 8. Bevorzugte Ausführungsformen sind in den jeweiligen abhängigen Ansprüchen beschrieben.

Der erfinderische Gedanke geht aus von einer herzustellenden Stromrichteranordnung, die vorteilhafterweise eine Kühleinrichtung und mindestens eine Stromrichterschaltung aufweist. Die Kühleinrichtung ihrerseits besteht hierbei aus einem metallischen Formkörper, der zumindest einen planaren Abschnitt einer Hauptfläche und dieser gegenüberliegend eine Mehrzahl von Kühlmitteln aufweist.

Die mindestens eine Stromrichterschaltung besteht ihrerseits aus mindestens einem Substrat mit einer Mehrzahl von ersten Leiterbahnen, wobei auf mindestens einer ersten Leiterbahn mindestens ein Leistungshalbleiterbauelement angeordnet und mittels einer Verbindungseinrichtung mit mindestens einem weiteren Leistungshalbleiterbauelement und / oder mindestens einer weiteren ersten Leiterbahn schaltungsgerecht verbunden ist. Vorteilhafterweise ist die Verbindungseinrichtung ausgebildet aus mindestens einer elektrisch isolierenden und einer elektrisch leitenden Folie.

Möglichst alle elektrisch leitenden, stoffschlüssigen Verbindungen, der Stromrichterschaltung sind als Drucksinterverbindungen gemäß dem Stand der Technik ausgebildet. Erfindungsgemäß sind hier auch die Stromrichterschaltungen mit der Kühleinrichtung stoffschlüssig verbunden. Hierzu sind diejenigen Verbindungen der jeweiligen Substrate der Stromrichterschaltung mit einem jeweiligen zugeordneten planen Abschnitt der Hauptfläche der Kühleinrichtung als Drucksinterverbindungen ausgebildet.

Die Herstellung einer derartigen Stromrichteranordnung mit einer Kühleinrichtung mit einem metallischen Formkörper und mit mindestens einem Substrat auf dem die weiteren Komponenten einer Stromrichterschaltung anordenbar sind, ist gekennzeichnet durch die Abfolge der folgenden wesentlichen Verfahrensschritte:
- Bereitstellung eines Druckgegenstücks einer Drucksintervorrichtung mit einer Ausnehmung zur Aufnahme der Kühleinrichtung, wobei diese Ausnehmung als Negativform der Kühleinrichtung ausgebildet ist; Hierbei muss die Ausnehmung die Kühleinrichtung nicht vollständig als Negativform nachbildet. Es ist ausreichend, wenn die Ausnehmung derart gestaltet ist, dass eine unbeabsichtigte Verwindung der Kühleinrichtung ausreichend sicher gestellt ist.
- Anordnen der Kühleinrichtung in dem Druckgegenstück; hierbei ist es nicht notwendig, dass der planare Abschnitt der Hauptfläche der Kühleinrichtung bündig mit eine Hauptfläche des Druckgegenstücks abschließt oder mit diesem fluchtet;
- Anordnen mindestens eines Substrats der Stromrichteranordnung auf dem zugeordneten planen Abschnitt der Hauptfläche der Kühleinrichtung, wobei die jeweiligen Kontaktflächen des Substrats und der Kühleinrichtung jeweils in dem zu verbindenden Bereich eine sinterfähige Oberfläche aufweisen und wobei zwischen diesen zu verbindenden Bereichen Sintermetall geeigneter Konsistenz angeordnet ist;
- Druck- und Temperatureinleitung auf das Substrat und die Kühleinrichtung zur Ausbildung der Drucksinterverbindung. Hierdurch wird eine stoffschlüssige Verbindung hergestellt, die eine hohe Wärmeleitfähigkeit, diejenige des Sintermetalls, aufweist. Zudem ist eine derartige Drucksinterverbindung, gerade auch im Vergleich zu einer möglichen alternativen Lotverbindung, sehr langzeitstabil.

Im Rahmen dieses Verfahrens ist es besonders vorteilhaft, wenn die die Negativform bildende, Ausnehmung der Kühleinrichtung derart ausgebildet ist, dass die darin angeordnete Kühleinrichtung unter Druckeinwirkung konkav in Bezug auf deren Hauptfläche verformt wird. Speziell sollte die Kühleinrichtung um nicht mehr als 2% bezogen auf die zugeordnete Längenausdehung des planaren Abschnitts der Hauptfläche verformt werden. Durch dies konkave Vorbiegung der Kühleinrichtung vor und während des Drucksinterprozesses wird erreicht, dass nach Beendigung der Druck- und Temperatureinwirkung der planare Abschnitt der Hauptfläche keine signifikante weder konkave noch konvexe Durchbiegung aufweist.

Weiterhin kann es bevorzugt sein, wenn auf dem Substrat erst nach dessen Verbindung mit der Kühleinrichtung Leistungshalbleiterbauelemente und weitere Verbindungseinrichtungen angeordnet werden. Herstellungstechnisch noch effizienter ist es allerdings wenn auf dem Substrat bereits vor dessen Verbindung mit der Kühleinrichtung die Leistungshalbleiterbauelemente und auch dazugehörige Verbindungseinrichtungen angeordnet waren.

Speziell bei großflächigen Drucksinterverbindungen zwischen dem Substrat und der Kühleinrichtung ist es besonders bevorzugt, wenn der metallische Formkörper aus einer Variante eines metallischen Werkstoff ausgebildet ist, dessen Elastizitätsmodul besonders gering ist. Hierfür eignen sich als metallischer Werkstoff vor allem Reinaluminium mit einem Reinheitsgrad von mindestens 99% oder getempertes Kupfer.

Der erfinderische Gedanke wird anhand der Ausführungsbeispiele der Fig. 1 bis 3 näher erläutert.

Fig. 1 zeigt eine erfindungsgemäße Stromrichteranordnung.

Fig. 2 zeigt einen Schritt einer ersten Ausgestaltung des erfindungsgemäßen Herstellungsverfahrens einer Stromrichteranordnung.

Fig. 3 zeigt den Schritt gemäß Fig. 2 in einer zweiten Ausgestaltung des erfindungsgemäßen Herstellungsverfahrens einer Stromrichteranordnung.

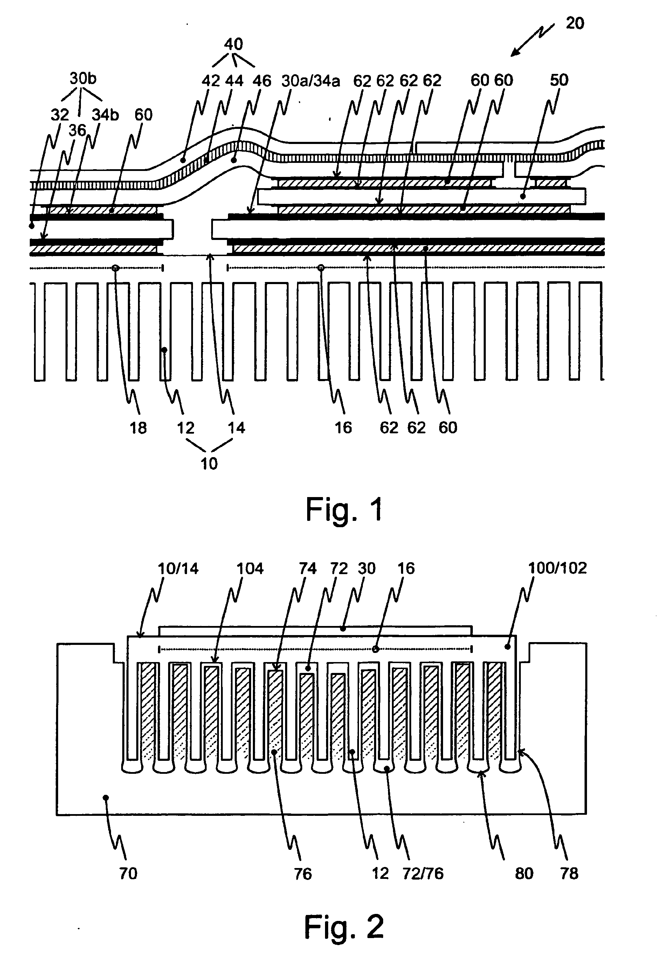

Fig. 1 zeigt nicht maßstäblich eine erfindungsgemäße Stromrichteranordnung. Diese besteht aus einer Kühleinrichtung (10) mit einer Mehrzahl von Kühlmitteln (12) und auf der gegenüberliegenden Seite dieser Kühlmittel (12) einer Hauptfläche (14) mit zwei planaren Abschnitten (16, 18). Die Kühleinrichtung (10) selbst besteht aus Reinaluminium mit einem Aluminiumgehalt von mindestens 99%. Dieses Reinaluminium weist gegenüber der üblicherweise für Kühleinrichtungen verwandten Aluminiumlegierung einen um mehr als 20% geringeren Elastizitätsmodul / Schermodul auf. Alternativ zu Reinaluminium kann auch getempertes Kupfer oder ein anderer metallischer Werkstoff, der einen entsprechend geeignet geringen Elastizitätsmodul aufweist Verwendung finden.

Auf den genannten planaren Abschnitten (16, 18) ist jeweils ein zugeordnetes Substrat (30 a/b), bestehend aus einem Isolierstoffkörper (32) und Leiterbahnen (34 a/b, 36) auf den jeweiligen Hauptflächen, einer Stromrichterschaltung (20) stoffschlüssig angeordnet. Diese stoffschlüssige Verbindung ist eine Drucksinterverbindung (60), da diese eine hohe Wärmeleitfähigkeit aufweist. Gleichzeitig weist eben diese Drucksinterverbindung (60) in Kombination mit der oben genannten Ausgestaltung der Kühleinrichtung (10) aus Reinaluminium eine besonders hohe Dauerhaltbarkeit auch bei den im Betrieb bekannten Temperaturwechseln auf.

Die Stromrichterschaltung (20) besteht aus den jeweiligen Substraten (30 a/b), welche jeweils auf ihrer der Kühleinrichtung (10) abgewandten Seite eine Mehrzahl von ersten Leiterbahnen (34 a/b)) aufweisen. Auf dem ersten Substrat (30a) ist auf einer dieser Leiterbahnen (34a) ein Leistungshalbleiterbauelement (50) angeordnet. Dieses Leistungshalbleiterbauelement (50) ist mit einer weiteren nicht dargestellten ersten Leiterbahn des gleichen Substrats (30a) sowie mit einer Leiterbahn (34b) des zweiten Substrats (30b) schaltungsgerecht verbunden.

Für diese elektrisch leitenden schaltungsgerechte Verbindung ist eine Verbindungseinrichtung (40) vorgesehen, die hier ausgebildet ist aus einer elektrisch isolierenden (44) und zwei elektrisch leitenden Folie (42, 46) in alternierender Stapelanordnung. Diese Verbindungseinrichtung (40) kann ebenso der Verbindung zu weiteren nicht dargestellten Leistungshalbleiterbauelementen dienen. Vorteilhafterweise sind auch die elektrisch leitenden Verbindungen der Verbindungseinrichtung (40) mit den Leistungshalbleiterbauelementen (50) und den ersten Leiterbahnen (34 a/b) als Drucksinterverbindungen (60) ausgebildet.

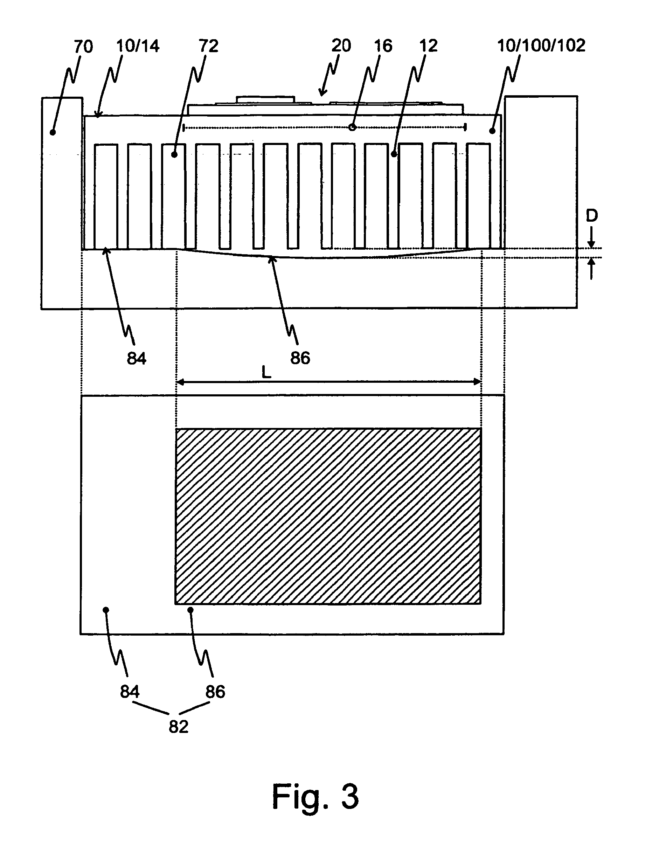

Zur Herstellung derjeweiligen Drucksinterverbindung (60), wovon in den Fig. 2 und 3 jeweils ein Teilschritt beschrieben ist, weisen die Verbindungsflächen (62) der jeweiligen Verbindungspartner, Substrat und plane Fläche der Kühleinrichtung, geeignete Oberflächen auf. Dies sind gemäß dem Stand der Technik Edelmetalloberflächen, zwischen denen eine Sintermetallschicht (60) nach dem Stand der Technik angeordnet ist.

Fig. 2 zeigt einen Schritt einer ersten Ausgestaltung des erfindungsgemäßen Herstellungsverfahrens einer Stromrichteranordnung (20). Dargestellt ist die Anordnung der Kühleinrichtung (10) mit einem nur schematisch angedeuteten Substrat (30) in einem Druckgegenstück (70) der Drucksintereinrichtung. Weitere Teile, wie die Druckeinrichtung zur Einleitung des Drucks im Rahmen der Drucksinterverbindung selbst sind hier nicht dargestellt. Die Kühleinrichtung (10) weist hier erfindungsgemäß einen planen Abschnitt (16) auf der Hauptfläche (14) auf, auf dem ein Substrat (30) ohne weitere Bauelemente angeordnet ist. Der metallische Formkörper (100) der Kühleinrichtung (10) weist weiterhin einen plattenartigen Teilkörper (102) und an diesem auf der der Hauptfläche (14) abgewandten Seite eine Mehrzahl von Kühlmitteln (12) auf. Diese Kühlmittel (12) sind gemäß dem Stand der Technik ausgebildete Kühlfinnen mit glatter oder geriffelter Oberfläche. Zwischen den Kühlmitteln (12) weist der Formkörper (100) plane Zwischenflächen (104) auf.

Zur Aufnahme des Formkörpers (100) der Kühleinrichtung (10) weist das Druckgegenstück (70) eine Ausnehmung (72) auf, die hier derart ausgebildet ist, dass die Kühleinrichtung (10) aus dem Druckgegenstück (70) teilweise herausragt. Das Druckgegenstück (70) weist weiterhin eine Mehrzahl von Auflageflächen (74) auf, die die Oberseite von Podesten (76) bilden, die in Richtung der Zwischenflächen (104) des Formkörpers (100) aufragen. Auf diesen Auflageflächen (74) kommen die Zwischenflächen (104) bei Druckeinleitung auf den Formkörper (100) der Kühleinrichtung (10) zu liegen.

Die Kühlmittel (12) ragen in Aufnahmen (76) der Ausnehmung (72), die die Zwischenräume der Podeste (74) bilden, des Druckgegenstücks (70) derart hinein, dass sie keinen Kontakt zur den Rändern (78) und der Bodenfläche (80) der Zwischenräume aufweisen.

Vorteilhafterweise ist das Druckgegenstück (70) derart ausgebildet, dass die Auflageflächen (74) zumindest in einer, bevorzugt allerdings in beiden lateralen Richtungen parallel zur Hauptfläche (14) der Kühleinrichtung (10) eine unterbrochene konkave Fläche bilden. Somit bildet die Ausnehmung (72) des Druckgegenstücks (70) eine Negativform zur Aufnahme des Formkörpers (100) der Kühleinrichtung (10) wobei unter Druckeinwirkung dieser konkav in Bezug auf seine Hauptfläche (14) verformt wird. Hierbei ist zu beachten, dass diese Verformung möglichst nicht mehr als 2% beträgt d.h., dass die Durchbiegung (D, vgl. Fig. 3) in der Mitte des verformten Bereichs 2% der Längenausdehnung (L, vgl. Fig. 3) des planen Abschnitts (16) der ersten Hauptfläche (14), auf dem das Substrat (30) angeordnet wird, nicht überschreitet.

Um die Verformbarkeit zu gewährleisten wird als Material des Formkörpers (100) der Kühleinrichtung (10) Reinaluminium mit einem Reinheitsgrad von mindestens 99% besser 99,5% oder getempertes Kupfer verwendet. Speziell bei Verwendung dieser Materialen ist eine großflächige Drucksinterverbindung (60) besonders robust für Anwendungen in Leistungshalbleitermodulen unter den hier anwendungsbedingt wechselden Betriebstemperaturen und weist eine exzellente Wärmeleitfähigkeit, speziell im Vergleich zu Wärmeleitpaste, auf.

Fig. 3 zeigt den Schritt gemäß Fig. 2 in einer zweiten Ausgestaltung des erfindungsgemäßen Herstellungsverfahrens einer Stromrichteranordnung. Hierbei ist wiederum der Formkörper (100) der Kühleinrichtung (10) angeordnet in einer Ausnehmung (72) des Druckgegenstücks (70) einer Drucksintereinrichtung in Schnittansicht sowie zusätzlich in Draufsicht dargestellt. Die Negativform dieser Ausgestaltung der Ausnehmung (72) weist eine Grundfläche (82) mit einem äußeren planen (84) und einem mittigen konkaven Flächenabschnitt (86) auf. Hierbei liegt der konkave Flächenabschnitt (86) nicht notwendigerweise zentral in der Grundfläche (82). Zudem ist die Oberfläche des konkaven Flächenabschnitts (86) nicht sphärisch ausgebildet um einen stetigen Übergang vom planen (84) zum konkaven Flächenabschnitt (86) zu ermöglichen.

Der Formkörper (100) der Kühleinrichtung (10) weist wiederum einen plattenartigen Teilkörper (102) und hieran angeordnete Kühlmittel (12) auf, die im einfachsten Fall aber nicht notwendigerweise alle die gleiche Länge aufweisen. Für andere geometrische Ausgestaltungen des Formkörpers (100) kann die Grundfläche (82) der Ausnehmung (72) des Druckgegenstücks (70) entsprechend angepasst werden. Zudem ist auf einem planen Abschnitt (16) der Hauptfläche (14) der Kühleinrichtung (10) eine Stromrichterschaltung (20) angeordnet und schematisch dargestellt. Diese Stromrichterschaltung (20) weist, vgl. Fig. 1, auf ihrer der Kühleinrichtung (10) abgewandten Seite eine Mehrzahl von Leiterbahnen (34) auf. Auf diesen Leiterbahnen (34) sind Leitungshalbleiterbauelemente (50) angeordnet und schaltungsgerecht miteinander bzw. mit weiteren Leiterbahnen verbunden. Diese Verbindung ist mittels der oben beschriebenen Verbindungseinrichtung (40) ausgebildet.

Dargestellt ist der Herstellungsschritt wiederum ohne Druckbeaufschlagung, d.h. die Hauptfläche (14) des Formkörpers (100) der Kühleinrichtung (10) ist plan. Bei Druckbeaufschlagung über die Stromrichterschaltung (20) auf die Kühleinrichtung (10) folgt diese der Formvorgabe der Negativform. Hierfür ist es besonders vorteilhaft, wenn der Formkörper (100) der Kühleinrichtung (10) einen besonders geringen Elastizitätsmodul aufweist. Diese Anforderungen werden besonders gut von Reinaluminium erfüllt.

Hierbei ist wiederum zu beachten, dass die Verformung unter Druckeinwirkung durch die Negativform derart begrenzt ist, dass die Durchbiegung (D) in der Mitte des verformten Bereichs 2% der Längenausdehnung (L) des planen Abschnitts (16) der ersten Hauptfläche (14) nicht überschreitet.

## Patentansprüche

1. Verfahren zur Herstellung einer Stromrichteranordnung mit einer Kühleinrichtung (10) mit einem metallischen Formkörper (100), der zumindest einen planaren Abschnitt (16, 18) einer Hauptfläche (14) und eine Mehrzahl von Kühfinnen als Kühlmitteln (12) aufweist, und mit mindestens einem Substrat (30 a/b) auf dem die weiteren Komponenten (50) einer Stromrichterschaltung (20) anordenbar sind, **gekennzeichnet durch** die Abfolge der folgenden wesentlichen Verfahrensschritte:
• Bereitstellung eines Druckgegenstücks (70) der Drucksintervorrichtung mit einer Ausnehmung (72) zur Aufnahme der Kühleinrichtung (10), wobei diese Ausnehmung (72) als Negativform der Kühleinrichtung (10) ausgebildet ist;
• Anordnen der Kühleinrichtung (10) in dem Druckgegenstück (70);
• Anordnen mindestens eines Substrats (30 a/b) der Stromrichterschaltung (20) auf dem zugeordneten planen Abschnitt (16, 18) der Hauptfläche (14) der Kühleinrichtung (10), wobei die jeweiligen Kontaktflächen (62) des Substrats (30) und der Kühleinrichtung (10) jeweils in dem zu verbindenden Bereich eine sinterfähige Oberfläche aufweisen und wobei zwischen diesen zu verbindenden Bereichen Sintermetall (60) geeigneter Konsistenz angeordnet ist;
• Druck- und Temperatureinleitung auf das Substrat (30 a/b) und die Kühleinrichtung (10) zur Ausbildung der Drucksinterverbindung.

2. Verfahren nach Anspruch 1, wobei
die, die Negativform bildende, Ausnehmung (72) des Druckgegenstücks (70) derart ausgebildet ist, dass die darin angeordnete Kühleinrichtung (10) unter Druckeinwirkung konkav in Bezug auf deren Hauptfläche (14) verformt wird.

3. Verfahren nach Anspruch 2, wobei
die Kühleinrichtung um nicht mehr als 2% bezogen auf die zugeordnete Längenausdehung (L) des planaren Abschnitts (16, 18) der Hauptfläche (14) verformt wird.

4. Verfahren nach Anspruch 1, wobei
auf dem Substrat (30), nach dessen Verbindung mit der Kühleinrichtung (10), Leistungshalbleiterbauelemente (50) und weiteren Verbindungseinrichtungen (40) angeordnet werden.

5. Verfahren nach Anspruch 1, wobei
auf dem Substrat (30) vor dessen Verbindung mit der Kühleinrichtung (10) bereits zumindest Leistungshalbleiterbauelemente (50) angeordnet waren.

6. Verfahren nach Anspruch 1, wobei
der metallische Formkörper (100) aus einer Variante eines metallischen Werkstoffs ausbildet ist, dessen Elastizitätsmodul besonders gering ist.

7. Verfahren nach Anspruch 6, wobei
der metallische Werkstoff Reinaluminium mit einem Reinheitsgrad von mindestens 99% oder getempertes Kupfer ist.

8. Stromrichteranordnung mit einer Kühleinrichtung (10) mit einem metallischen Formkörper (100), der zumindest einen planaren Abschnitt (16, 18) einer Hauptfläche (14) und eine Mehrzahl von Kühlfinnen als Kühlmitteln (12) aufweist, und mit mindestens einer Stromrichterschaltung (20) mit mindestens einem eine Mehrzahl von ersten Leiterbahnen (34 a/b) aufweisenden Substrat (30 a/b), wobei auf mindestens einer ersten Leiterbahn (34 a/b) mindesfens ein Leistungshalbleiterbauelement(50) angeordnet und mittels einer Verbindungseinrichtung (40) mit mindestens einem weiteren Leistungshalbleiterbauelement (40) und / oder mindestens einer weiteren ersten Leiterbahn (34 a/b) schaltungsgerecht verbunden ist, **dadurch gekennzeichnet,**
**dass** eine stoffschlüssige Verbindung zwischen einem planen Abschnitt (16, 18) der Hauptfläche (14) der Kühleinrichtung (10) und der Stromrichterschaltung (20) mittels einer Drucksinterverbindung ausgebildet ist.

9. Stromrichteranordnung nach Anspruch 1, wobei
der metallische Formkörper (100) aus einer Variante eines metallischen Werkstoffs ausbildet ist, dessen Elastizitätsmodul besonders gering ist.

10. Stromrichteranordnung nach Anspruch 2, wobei
der metallische Werkstoff Reinaluminium mit einem Reinheitsgrad von mindestens 99% oder getempertes Kupfer ist.

## Claims

1. A method for producing a power converter arrangement with a cooling apparatus (10) with a metallic shaped body (100), which has at least one planar section (16, 18) of a main surface (14) and a plurality of cooling fins as cooling means (12) and with at least one substrate (30 a/b), on which the further components (50) of a power converter circuit (20) can be arranged, **characterised by** the sequence of the following essential method steps:
• Provision of a pressure counterpart (70) of the pressure sintering device with a recess (72) for accommodating the cooling apparatus (10), wherein this recess (72) is constructed as the negative shape of the cooling apparatus (10);
• Arrangement of the cooling apparatus (10) in the pressure counterpart (70);
• Arrangement of at least one substrate (30 a/b) of the power converter circuit (20) on the associated flat section (16,18) of the main surface (14) of the cooling apparatus (10), wherein the respective contact surfaces (62) of the substrate (30) and the cooling apparatus (10) in each case have a sinterable surface in the region to be connected and wherein sintered metal (60) of suitable consistency is arranged between these regions to be connected;
• Introduction of pressure and temperature onto the substrate (30 a/b) and the cooling apparatus (10) for constructing the pressure sintered connection.

2. The method according to Claim 1, wherein
the recess (72) of the pressure counterpart (70) forming the negative shape is constructed in such a manner that the cooling apparatus (10) arranged therein is deformed in a concave manner with respect to the main surface (14) thereof under the action of pressure.

3. The method according to Claim 2, wherein
the cooling apparatus is not deformed by more than 2% with respect to the assigned longitudinal extent (L) of the planar section (16, 18) of the main surface (14).

4. The method according to Claim 1, wherein
power semiconductor components (50) and further connection apparatuses (40) are arranged on the substrate (30) following the connection thereof to the cooling apparatus (10).

5. The method according to Claim 1, wherein
power semiconductor components (50) at least were arranged on the substrate (30) even before the connection thereof to the cooling apparatus (10).

6. The method according to Claim 1, wherein
the metallic shaped body (100) is constructed from a variant of a metallic material, the modulus of elasticity of which is particularly small.

7. The method according to Claim 6, wherein
the metallic material is pure aluminium with a purity grade of at least 99% or tempered copper.

8. A power converter arrangement with a cooling apparatus (10) with a metallic shaped body (100), which has at least one planar section (16, 18) of a main surface (14) and a plurality of cooling fins as cooling means (12) and with at least one power converter circuit (20) with at least one substrate (30 a/b) having a plurality of first conductor tracks (34 a/b), wherein at least one power semiconductor component (50) is arranged on at least one first conductor track (34 a/b) and is connected by means of a connection apparatus (40) to at least one further power semiconductor component (40) and/or at least one further conductor track (34 a/b) appropriately for the circuit, **characterised in that** a materially bonded connection between a flat section (16, 18) of the main surface (14) of the cooling apparatus (10) and the power converter circuit (20) is constructed by means of a pressure sintered connection.

9. The power converter arrangement according to Claim 1,
wherein
the metallic shaped body (100) is constructed from a variant of a metallic material, the modulus of elasticity of which is particularly small.

10. The power converter arrangement according to Claim 2,
wherein
the metallic material is pure aluminium with a purity grade of at least 99% or tempered copper.

## Revendications

1. Procédé pour fabriquer un convertisseur présentant un dispositif de refroidissement (10) avec un corps moulé (100) métallique, qui présente au moins un tronçon (16, 18) plan, une surface principale (14) et une pluralité de rigoles de refroidissement comme moyens de refroidissement (12), et au moins un substrat (30 a/b), sur lequel les autres composants (50) d'un circuit convertisseur (20) peuvent être disposés, **caractérisé par** la succession des étapes de procédé importantes suivantes :
• mise à disposition d'une pièce inverse de pression (70) du dispositif de frittage sous pression avec un évidement (72) pour le logement du dispositif de refroidissement (10), cet évidement (72) étant conçu comme forme négative du dispositif de refroidissement (10) ;
• mise en place du dispositif de refroidissement (10) dans la pièce inverse de pression (70) ;
• mise en place d'au moins un substrat (30 a /b) du circuit convertisseur (20) sur le tronçon (16, 18) plan associé de la surface principale (14) du dispositif de refroidissement (10), les surfaces de contact (62) respectives du substrat (30) et du dispositif de refroidissement (10) présentant une surface apte au frittage à chaque fois dans la zone à relier et du métal fritté (60) de consistance appropriée étant disposé entre ces zones à relier ;
• application de pression et de température sur le substrat (30 a/b) et le dispositif de refroidissement (10) pour la formation de la liaison de frittage par pression.

2. Procédé selon la revendication 1, l'évidement (72), formant la forme négative, de la pièce inverse de pression (70) étant conçu de telle sorte que le dispositif de refroidissement (10) disposé à l'intérieur est déformé sous l'effet de pression de façon concave par rapport à sa surface principale (14).

3. Procédé selon la revendication 2, le dispositif de refroidissement n'étant pas déformé de plus de 2 % par rapport à l'extension en longueur (L) associée du tronçon plan (16, 18) de la surface principale (14).

4. Procédé selon la revendication 1,
des composants à semi-conducteurs de puissance (50) et d'autres systèmes de liaison (40) étant disposés sur le substrat (30), après sa liaison avec le dispositif de refroidissement (10).

5. Procédé selon la revendication 1,
déjà au moins les composants à semi-conducteurs de puissance (50) étant disposés sur le substrat (30) avant sa liaison avec le dispositif de refroidissement (10).

6. Procédé selon la revendication 1,
le corps moulé (100) métallique étant formé d'une variante d'un matériau métallique, dont le module d'élasticité est particulièrement faible.

7. Procédé selon la revendication 6,
le matériau métallique étant de l'aluminium pur avec un degré de pureté d'au moins 99 % ou du cuivre malléabilisé.

8. Convertisseur doté d'un dispositif de refroidissement (10) avec un corps moulé (100) métallique, qui présente au moins un tronçon (16, 18) plan, une surface principale (14) et une pluralité de rigoles de refroidissement comme moyens de refroidissement (12), et d'au moins un circuit convertisseur (20) avec au moins un substrat (30 a/b) présentant une pluralité de premières pistes conductrices (34 a/b), au moins un élément à semi-conducteurs de puissance (50) étant disposé sur au moins une première piste conductrice (34 a/b) et étant relié de façon conforme au circuit au moyen d'un dispositif de liaison (40) à au moins un autre composant à semi-conducteurs de puissance (40) et/ou au moins une autre piste première conductrice (34 a/b), **caractérisé en ce que**
une liaison par adhésion de matière est réalisée entre une partie (16, 18) plane de la surface principale (14) du dispositif de refroidissement (10) et du circuit convertisseur (20) au moyen d'une liaison de frittage par pression.

9. Convertisseur selon la revendication 1,
le corps moulé métallique (100) étant conçu à partir d'une variante d'un matériau métallique, dont le module d'élasticité est particulièrement faible.

10. Convertisseur selon la revendication 2,
le matériau métallique étant de l'aluminium pur avec un degré de pureté d'au moins 99 % ou du cuivre malléabilisé.
